# FASCICULE DE BREVET EUROPEEN

(11) **EP 3 442 027 B1**
(45) Date de publication et mention de la délivrance du brevet: **03.11.2021**
(21) Numéro de dépôt: 18187257.3
(22) Date de dépôt: 03.08.2018
(51) Int. Cl.: H01L 29/66, H01L 29/775, H01L 29/06, H01L 29/08

(54) **PROCEDE DE FORMATION DE REGIONS D'EXTENSION DOPEES DANS UNE STRUCTURE A NANOFILS SUPERPOSES**
VERFAHREN ZUR BILDUNG VON DOTIERTEN ERWEITERUNGSBEREICHEN IN EINER STRUKTUR MIT ÜBEREINANDER ANGEORDNETEN NANODRÄHTEN
METHOD FOR FORMING DOPED EXTENSION REGIONS IN A STRUCTURE HAVING STACKED NANOWIRES

(30) Priorité: 11.08.2017 FR 1757673
(43) Date de publication de la demande: 13.02.2019
(73) Titulaire: Commissariat à l'énergie atomique et aux énergies alternatives, 75015 Paris (FR); International Business Machines Corporation, Yorktown Heights, NY 10598 (US)
(72) Inventeur: COQUAND, Rémi, 73800 LES MARCHES (FR); LOUBET, Nicolas, GUILDERLAND, NY New York 12084 (US); REBOH, Shay, 38054 GRENOBLE CEDEX 09 (FR); CHAO, Robin, NEW YORK, NY New York 12047 (US)
(74) Mandataire: Brevalex

(56) Documents cités:
- US-A1- 2014 014 904
- US-A1- 2015 340 457
- US-A1- 2015 372 115
- US-A1- 2017 069 763
- US-A1- 2017 194 430

## Description

### DOMAINE TECHNIQUE ET ART ANTÉRIEUR

La présente invention se rapporte au domaine de la micro-électronique et plus particulièrement à celui des transistors, et concerne la réalisation d'au moins un transistor doté d'une structure semi-conductrice de canal sous forme d'une pluralité de barreaux semi-conducteurs encore appelés « nano-fils» disposés les uns au-dessus des autres.

Le document « Si Nanowire CMOS Fabricated with Minimal Deviation from RMG FinFET Technology Showing Record Performance », de Lauer et al. 2015 Symposium on VLSI Technology Digest of Technical Papers présente par exemple un procédé de réalisation de transistor à structure de canal sous forme de nano-fils disposés les uns au-dessus des autres. Une grille enrobante entoure des portions de nano-fils de cette structure.

Le document « Opportunities and Challenges of Nanowire-Based CMOS Technologies », de Barraud et al., SOI-3D-Subthreshold Microelectronics Technology Unified Conférence (S3S), 2015 IEEE présente un autre exemple de procédé de réalisation de transistors à grille enrobante et à structure semi-conductrice de canal sous forme de nano-fils disposés les uns au-dessus des autres.

Ces exemples de procédé comprennent la formation d'un empilement de couches semi-conductrices avec une alternance de couches à base d'un premier matériau semi-conducteur tel que du Si et de couches à base d'un deuxième matériau semi-conducteur tel que du SiGe.

Pour réaliser des régions de source et de drain à partir d'une telle structure, on peut envisager de réaliser une croissance épitaxiale d'un matériau semi-conducteur dopé *in-situ* sur des flancs latéraux de la structure.

Pour permettre de diminuer les résistances d'accès au canal, on cherche de préférence à doper des régions semi-conductrices dites « d'extension » situées entre les régions de source et de drain et la structure de canal.

Pour cela, après épitaxie, une diffusion des dopants des régions de source et de drain peut être envisagée. Cependant, cette diffusion peut s'avérer difficile à contrôler. Or, en même temps que l'on souhaite diminuer les résistances d'accès, on cherche à empêcher un dopage de la structure de canal.

Le document US2015/0372115A1 prévoit un procédé de réalisation d'un transistor comportant une structure semi-conductrice dotée de barreaux semi-conducteurs à base d'un premier matériau semi-conducteur et à base d'un deuxième matériau semi-conducteur et dans lequel on effectue un dopage de portions latérales de la structure, puis on forme des blocs de source et de drain au niveau de régions d'extrémités desdites portions latérales, puis on retire une grille sacrificielle avant de retirer les deuxième barreaux. Ensuite, on réalise des espaceurs internes isolants, puis on forme une grille de remplacement. Le document US2017/194430 propose un procédé similaire, sans étape de dopage de portions latérales mais dans lequel une couche mince diélectrique est déposée sur les extrémités des barreaux semi-conducteurs.

La réalisation des espaceurs internes isolants nécessite un dépôt de matériau isolant que l'on doit ensuite retirer de portions des barreaux destinées à former la région de canal. Cela peut entraîner une détérioration de la région de canal préjudiciable aux performances du transistor.

Par ailleurs, la formation des blocs de source et de drain par croissance épitaxiale sur des portions dopées des barreaux peut s'avérer difficile à mettre en œuvre.

Il se pose donc le problème de trouver un nouveau procédé amélioré vis-à-vis d'inconvénients donnés ci-dessus.

### EXPOSÉ DE L'INVENTION

Un but de la présente invention est de pouvoir doper des régions d'extension dans une structure semi-conductrice formée de barreaux semi-conducteurs disposés les uns au-dessus des autres aptes à former un canal de transistor, et ce en cherchant à éviter de doper des régions du canal.

Le but énoncé ci-dessus est atteint à l'aide d'un procédé de réalisation d'une structure semi-conductrice dotée de barreaux semi-conducteurs disposés les uns au-dessus des autres, ce procédé comprenant les étapes de :
- réalisation sur un support d'une structure empilée comportant une alternance de plusieurs premiers barreaux à base d'un premier matériau et de plusieurs deuxièmes barreaux à base d'un deuxième matériau, le deuxième matériau étant semi-conducteur, les deuxièmes barreaux comportant des portions latérales saillantes par rapport aux portions latérales des premiers barreaux, puis,
- dopage en surface des portions latérales, puis
- formation d'espaceurs internes isolants contre les premiers barreaux, puis
- formation de blocs de source et de drain par croissance de matériau semi-conducteur au niveau de régions d'extrémités desdites portions latérales saillantes.

Le dopage effectué avant la formation de bloc de source et de drain permet d'obtenir des régions d'extension dopées sans nécessairement avoir à contrôler précisément ultérieurement une diffusion de dopants issus des blocs de source et de drain.

Dans une telle structure on obtient avantageusement des régions d'extensions auto-alignées avec les espaceurs internes isolants.

Les espaceurs internes isolants sont par ailleurs réalisés sans que l'on détériore des portions de la structure destinées à former la région de canal.

Le dopage en surface des portions latérales saillantes peut être effectué de sorte à doper une face inférieure, une face latérale et une face supérieure des portions saillantes. On réalise ainsi avantageusement un dopage de manière conforme et de sorte à suivre la géométrie des portions latérales des deuxièmes barreaux. Cela permet d'obtenir un dopage plus uniforme des régions d'extensions et d'obtenir des résistances d'accès plus uniformes.

Pour réaliser le dopage en surface des portions latérales, sans doper le cœur de la structure, on effectue de préférence un procédé de dopage à faible énergie. Ainsi, la majorité des dopants sont situés dans une épaisseur en surface typiquement inférieure à 3 nm. Parfaible énergie, on entend une énergie typiquement inférieure à 2 keV cette énergie dépendant des espèces en jeu. Par exemple, pour un dopage à l'aide de BF₂ on prévoit une énergie inférieure à 1 keV.

Selon une possibilité de mise en œuvre, le dopage en surface des portions latérales saillantes comprend un dépôt d'une fine couche sur les portions latérales saillantes, cette fine couche étant à base d'un matériau dopé ou bien d'une espèce dopante sur les portions latérales saillantes. Un tel type de dopage permet d'obtenir une zone dopée conforme et ce sans endommager la structure cristalline des portions latérales saillantes.

Selon une autre possibilité de mise en œuvre, le dopage en surface des portions latérales saillantes peut être réalisé à l'aide d'un plasma. Un tel type de dopage permet également d'obtenir une zone dopée conforme et ce sans endommager la structure cristalline des portions latérales saillantes.

Après formation des espaceurs internes isolants et préalablement à la formation des blocs de source et de drain, on effectue avantageusement un recuit thermique de diffusion et d'activation de dopants.

La formation d'espaceurs internes isolants contre les premiers barreaux permet de réaliser une barrière d'encapsulation des dopants afin d'éviter une perte de dose dans des zones d'intérêt. La diffusion des dopants permet d'obtenir un dopage plus homogène des régions d'extension.

La formation des espaceurs internes isolants peut comprendre des étapes de :
- dépôt d'une couche de matériau diélectrique sur l'empilement puis,
- gravure de la couche de matériau diélectrique.

La gravure de la couche de matériau diélectrique est réalisée de sorte à retirer en outre une épaisseur de matériau aux extrémités des portions latérales saillantes et à dévoiler des régions d'extrémités des deuxièmes barreaux semi-conducteurs.

Une fois ce retrait effectué, les régions situées aux extrémités des nano-fils sont alors de bonne qualité cristalline, ce qui permet de favoriser une croissance par épitaxie des blocs de source-drain et/ou d'améliorer la qualité cristalline du matériau des blocs de source et de drain.

En variante, après gravure de la couche de matériau diélectrique, on réalise en outre une gravure ou un nettoyage, ou une gravure puis un nettoyage, de sorte à retirer une épaisseur de matériau aux extrémités des portions latérales saillantes et à dévoiler des régions d'extrémités des deuxièmes barreaux semi-conducteurs.

Le retrait par gravure ou nettoyage de matériau aux extrémités des barreaux permet également d'obtenir une interface de qualité avant une étape d'épitaxie pour former des blocs de source et de drain.

La formation de ladite structure empilée peut comprendre des étapes de :
- réalisation d'un empilement comportant une alternance de couches à base du premier matériau et de couches à base du deuxième matériau,
- formation d'un masquage sur ledit empilement,
- gravure anisotrope de l'empilement.

Le masquage peut être formé d'un bloc de grille factice, encore appelée grille sacrificielle, et d'espaceurs isolants agencés de part et d'autre de ce bloc, les espaceurs isolants étant à base d'un autre matériau, diélectrique et différent dudit matériau donné, le procédé comprenant en outre, après croissance du matériau semi-conducteur au niveau de régions d'extrémités desdites portions latérales, des étapes de :
- formation d'une couche isolante d'encapsulation des blocs de source et de drain, de sorte qu'une face supérieure du bloc de grille factice est dévoilée,
- retrait du bloc de grille factice par gravure sélective dudit matériau donné puis des premiers barreaux par gravure sélective dudit premier matériau, de sorte à former une cavité,
- formation d'une grille de remplacement dans la cavité.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A à 1K, illustrent un exemple de procédé de réalisation d'une structure de canal de transistor à nano-fils ou barreaux semi-conducteurs disposés les uns au-dessus des autres et à grille enrobante ;
- les figures 2A-2B illustrent des étapes de dopage et de diffusion de dopants effectuées afin de réaliser un dopage conforme et maitrisé de régions d'accès à la structure de canal encore appelées régions d'extension ;
- les figures 3A à 3B illustrent une gravure ou nettoyage d'extrémités de portions semi-conductrices sur lesquelles une croissance de blocs de source et de drain est destinée à être réalisée.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

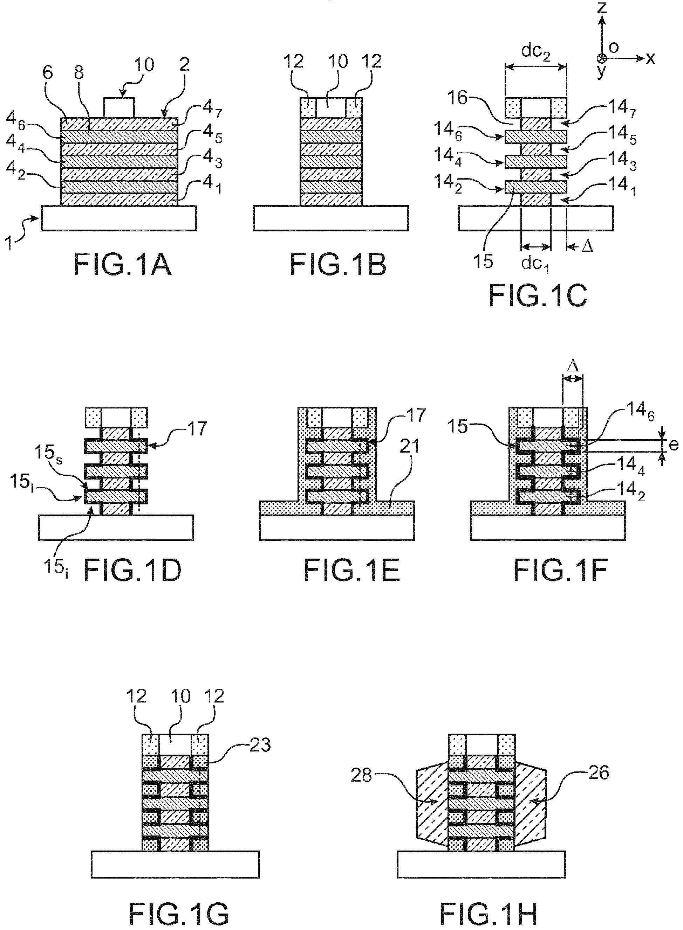

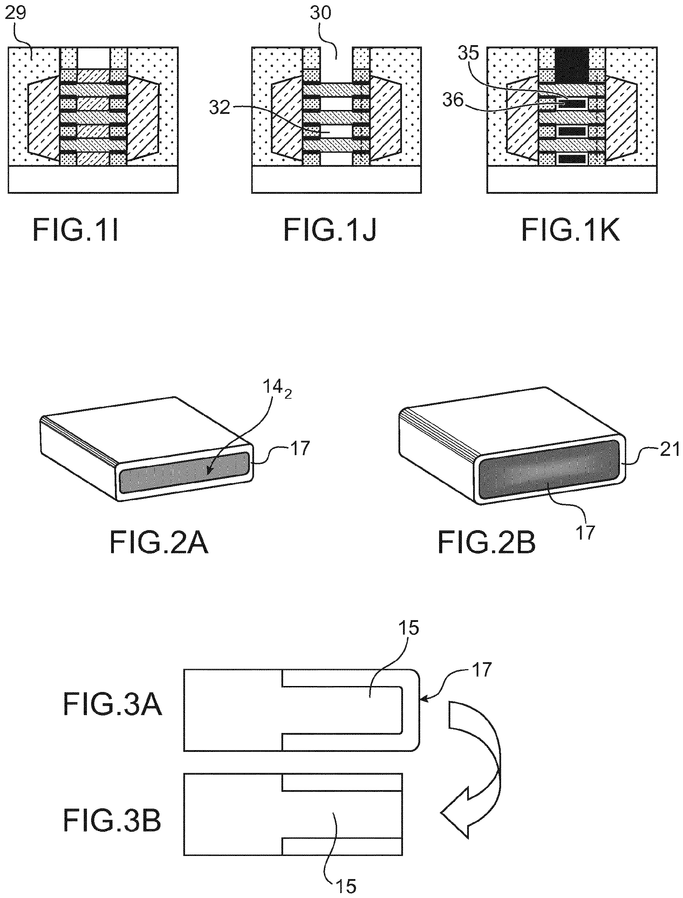

Un exemple de procédé de réalisation d'un dispositif microélectronique à transistors doté d'au moins une structure semi-conductrice à barreaux semi-conducteurs superposés va à présent être décrit en liaison avec les figures 1A-1K et 2A-2B.

Le matériau de départ du procédé peut être un substrat 1 de type communément appelé « bulk » formé d'une couche semi-conductrice ou d'un substrat de type semi-conducteur sur isolant comprenant une couche de support semi conductrice recouverte d'une couche isolante par exemple à base SiO₂, elle-même recouverte d'une fine couche semi-conductrice superficielle.

On réalise tout d'abord sur ce substrat 1 un empilement de couches. Cet empilement 2 peut être formé d'une alternance de couches notées 4₁, 4₃, 4s, 4₇ à base d'un premier matériau 6, qui peut être semi-conducteur, et de couches 4₂, 4₄, 4₆ à base d'un deuxième matériau 8 qui est semi-conducteur et différent du premier matériau 6. Le premier matériau 6 est susceptible de pouvoir être gravé de manière sélective vis-à-vis du deuxième matériau 8. Typiquement, l'empilement 2 est formé par épitaxies successives de couches semi-conductrices. Par exemple, le premier matériau 6 est à base de silicium germanium tandis que le deuxième matériau 8 est en silicium.

Selon une possibilité de mise en œuvre, les couches 4₁, 4₃, 4₅, 4₇ à base du premier matériau 6 peuvent avoir une épaisseur comprise par exemple entre 4 et 12 nanomètres, typiquement de l'ordre de 8 nm. Les couches 4₁, 4₃, 4₅, 4₇ à base du premier matériau 6 sont dans cet exemple plus épaisses que les couches 4₂, 4₄, 4₆ à base du deuxième matériau 8. Les couches 4₂, 4₄, 4₆ peuvent, quant à elles, avoir une épaisseur, comprise par exemple entre 4 nm et 10 nm, typiquement de l'ordre de 7 nm nanomètres. De préférence, on prévoit les couches 4₁, 4₃, 4₅, 4₇ (ou 4₂, 4₄, 4₆) d'un même matériau 6 (resp. 8) d'épaisseurs égales ou sensiblement égales entre elles.

On forme ensuite un bloc 10 de grille factice sur l'empilement 2 (figure 1A), c'est-à-dire un bloc sacrificiel reproduisant celui d'une grille de transistor. Le bloc 10 de grille factice est formé par dépôt d'une couche à base d'un matériau donné, par exemple tel que du polysilicium.

Ensuite, on peut former une couche de résine photosensible, par exemple à base de polyimide sur la couche de matériau donné, et l'on définit dans la couche de résine un masque de résine par photolithographie. Puis, on effectue une gravure anisotrope de la couche de matériau donné protégée par le masque de résine, afin de réaliser le bloc de grille factice sous le masque de résine. Après formation du bloc 10 de grille factice, le masque de résine est retiré.

On forme ensuite des espaceurs 12 de part et d'autre du bloc 10 de grille factice. Ces espaceurs 12 sont disposés contre des flancs latéraux du bloc 10 de grille factice et typiquement à base d'un matériau diélectrique. On choisit de préférence le matériau donné du bloc 10 de grille factice différent de celui des espaceurs 12 et apte à être gravé sélectivement vis-à-vis de celui des espaceurs 12. Les espaceurs 12 peuvent être par exemple à base de SiCBN.

On procède ensuite à une étape de gravure de l'empilement 2 de couches, afin de reproduire dans l'empilement 2 le motif du bloc 10 de grille factice et des espaceurs 12, l'ensemble du bloc 10 et des espaceurs 12 formant un masquage. La gravure est de préférence anisotrope, et réalisée par exemple à l'aide d'un plasma à base de CF₄.

On supprime ainsi des parties de l'empilement 2 qui ne sont pas situées sous le masquage 10-12.

La figure 1B illustre une structure empilée obtenue à l'issue de cette gravure. Cette structure est formée d'une alternance de couches gravées typiquement sous forme barreaux 14₁, 14₃, 14₅, 14₇, à base du premier matériau 6 et de barreaux 14₂, 14₄, 14₆, à base du deuxième matériau 8. Les barreaux 14₁, 14₃, 14₅, 14₇, 14₂, 14₄, 14₆ empilés que l'on appelle indifféremment « nano-fils » sont par exemple de forme parallélépipédique ou sensiblement parallépipédique.

Ensuite, on effectue une gravure partielle de portions de la structure empilée, qui peut être isotrope, et sélective, de manière à réaliser un retrait partiel de certains des barreaux 14₁, 14₃, 14₅, 14₇, de l'empilement. Dans cet exemple, on retire partiellement les barreaux à base du premier matériau 6. La gravure est de préférence une gravure isotrope sélective d'un premier matériau semi-conducteur vis-à-vis d'un deuxième matériau semi-conducteur. Par exemple, dans le cas où les barreaux 14₁, 14₃, 14₅, 14₇ sont à base de SiGe tandis que les couches 14₂, 14₄, 14₆ sont à base par exemple de silicium, la gravure peut être une gravure isotrope du SiGe, sélective vis-à-vis du Si. Une telle gravure peut être réalisée par exemple à l'aide de HCl sous forme de gaz, ou d'un nettoyage de type SC1 dilué chaud (NH₄O₄+H₂O₂).

De cette manière on réduit les dimensions latérales des barreaux 14₁, 14₃, 14₅, 14₇ à base du premier matériau 6. On voit sur la figure 1C que l'on réduit en particulier leur dimension critique. Par« dimension critique », on entend tout au long de la description la plus petite dimension d'un élément hormis son épaisseur, la dimension critique étant une dimension mesurée dans une direction parallèle au plan principal du support (le plan principal du support étant quant à lui un plan du support défini sur les figures comme un plan parallèle au plan [O; x; y] d'un repère orthogonal [O; x; y; z]).

On obtient ainsi une structure empilée comportant une alternance de barreaux 14₁, 14₃, 14s, 14₇ à base du premier matériau 6 et de barreaux 14₂, 14₄, 14₆ à base d'un deuxième matériau 8 ayant des dimensions latérales plus faibles que celles des barreaux 14₁, 14₃, 14₅, 14₇. Sur la vue de la figure 1C, cela se traduit par une alternance de barreaux 14₁, 14₃, 14₅, 14₇ à base du premier matériau 6 et ayant une première dimension critique dc₁ et de barreaux 14₂, 14₄, 14₆ à base d'un deuxième matériau 8 et ayant une deuxième dimension critique dc₂ supérieure à la première dimension critique dc₁.

Les barreaux 14₂, 14₄, 14₆ à base du deuxième matériau 8 comportent ainsi des portions latérales 15 qui dépassent au niveau des régions latérales de la structure empilée par rapport aux barreaux 14₁, 14₃, 14₅, 14₇ à base du premier matériau 6. Un dépassement Δ de la partie saillante des barreaux 14₂, 14₄, 14₆ à base du deuxième matériau semi-conducteur 8 compris par exemple entre 2 nm et 10 nm, en particulier de 6nm peut être par exemple prévu.

Du fait de la différence de dimensions latérales entre les barreaux 14₁, 14₃, 14₅ 14₇ d'une part et les barreaux 14₂, 14₄, 14₆ d'autre part, la structure comporte un profil dentelé, avec des encoches 16 ou rainures 16 au niveau de ses flancs latéraux.

On réalise ensuite un dopage des faces latérales de la structure empilée comportant une indentation, et en particulier au niveau des barreaux 14₂, 14₄, 14₆ à base du deuxième matériau 8 qui font saillie. Un dopage de faces latérales ou flancs latéraux des portions dépassant ou faisant saillie peut être en particulier prévu afin d'obtenir une zone dopée 17 sous le masquage 10-12 dont l'agencement suit le profil dentelé. Lorsque les barreaux 14₂, 14₄, 14₆ sont en silicium on dope ainsi le silicium saillant de la structure.

On privilégie en particulier un procédé de dopage qui permette un dopage conforme et permette de doper aussi bien une face inférieure 15i qu'une face supérieure 15s et une face latérale 15l des portions latérales 15 des barreaux 14₂, 14₄, 14₆ faisant saillie.

Le type de dopage N ou P est quant à lui choisi en fonction du type de transistor que l'on souhaite réaliser.

Selon une possibilité de mise en œuvre, l'apport de dopants peut être effectué par dépôt d'une fine couche riche en dopants par exemple à base de Bore ou de Phosophore ou d'Arsenic. Cette fine couche peut être par exemple une couche d'espèce dopante telle qu'une couche de type MLD (pour « mono layer doping ») dont une réalisation est par exemple décrite dans le document « Wafer scale, sub-5 nm Junction Formation by Monolayer Doping and Conventional Spike Annealing », de Ho et al., Nanoletters 2009 Vol.9, No.2 725-730. L'espèce dopante est ensuite diffusée dans le matériau semi-conducteur.

Avantageusement, on utilise une technique de dépôt conforme pour réaliser la fine couche riche en dopants, en particulier par un procédé de type ALD (pour « Atomic Layer Deposition ») ou PEALD (pour « Plasma Enhanced Atomic Layer Deposition », i.e ALD assistée par plasma). Des techniques de type CVD (« Chemical Vapor Déposition » i.e. dépôt chimique en phase vapeur), PE-CVD (« Plasma Enhanced Chemical Vapor Deposition ») ou SA-CVD (« subatmospheric Chemical Vapor Déposition) peuvent être également mises en œuvre.

Un procédé de type IADD (pour « Ion Assisted Deposition and Doping ») peut également être utilisé pour réaliser la fine couche riche en dopants

La fine couche utilisée pour effectuer le dopage peut être également une couche en un matériau riche en dopants, par exemple un matériau semi-conducteur tel que du Si ou un matériau diélectrique tel que du SiN, de préférence fortement dopé. Pour un dopage au Bore, la fine couche peut être enrichie à l'aide de BF₃ ou de B₂F₄. La fine couche peut avoir une épaisseur de l'ordre de un ou plusieurs nanomètres, par exemple de 1nm. On prévoit de préférence une fine couche très riche en espèce dopante par exemple supérieure à 90%.

Une méthode de dopage par ALD tel que décrite par exemple dans le document « ALD Process for Dopant-Rich Films on Si », Seidel et al., 2016 21st International Conférence on Ion Implantation Technology (IIT) peut être en particulier mise en œuvre.

En variante, une méthode de dopage telle que décrite par exemple dans le document US8°796°124°B2 ou dans le document US°9°450°097B2 peut être utilisée.

Un avantage d'une telle technique de dopage est qu'une forte concentration de dopants en surface des portions saillantes des barreaux 14₂, 14₄, 14₆ peut être obtenue.

Un dopage selon une technique telle que décrite précédemment permet également de doper la structure dentelée sans endommager les surfaces dopées et sans pénétrer dans des zones destinées à former une structure de canal. On évite ainsi de doper des parties situées en regard de la structure de grille factice 12.

Une telle technique de dopage permet également d'avoir un dopage uniforme entre une face inférieure 15i des portions latérales 15 de barreaux 14₂, 14₄, 14₆, faisant saillie, une face latérale 15l et une face supérieure 15s de ces mêmes portions latérales 15, la fine couche à base d'espèce dopante ou de matériau dopé pouvant se répartir sur chacune de ces faces 15i, 15l, 15s (figure 1D).

Une autre variante prévoit un dopage à l'aide d'un faisceau d'ions à faible énergie, c'est-à-dire typiquement inférieure à 2keV.

La figure 2A donne une vue en perspective d'une portion latérale 15 d'un barreau 14₂ et montre une répartition de la zone dopée 17 obtenue formant une enveloppe autour d'une région centrale ou cœur 18 du barreau 14₂ non dopé.

En variante du dopage obtenu par formation d'une fine couche de matériau dopée ou d'espèce dopante, on peut effectuer un dopage à l'aide d'un plasma selon une technique par exemple telle que décrite dans le document « plasma Doping of Silicon Fin Structures », de Felch et al., 11th International Workshop on Junction Technology (IWJT), 2011. Un tel type de dopage peut également permettre de former une zone dopée d'épaisseur conforme sur les portions latérales 15 faisant saillie des barreaux 14₂, 14₄, 14₆, et permettre de doper une épaisseur en surface des barreaux 14₂, 14₄, 14₆, sans doper le cœur de ces barreaux 14₂, 14₄, 14₆ et sans endommager leur surface externe.

On réalise ensuite (figure 1E) un dépôt conforme de matériau diélectrique 21 afin de recouvrir la structure empilée et de combler les encoches 16 ou rainures 16 formées entre les portions latérales 15 de barreaux semi-conducteurs 14₂, 14₄, 14₆ faisant saillie. Le matériau diélectrique 21 peut être par exemple à base de nitrure de silicium (SiN).

On peut ensuite réaliser au moins un recuit thermique adapté de sorte à faire diffuser les dopants et augmenter l'épaisseur de la zone dopée 17 dans les portions 15 faisant saillie des barreaux semi-conducteurs 14₂, 14₄, 14₆ (figure 1F). Une diffusion sur toute l'épaisseur des barreaux peut être mise en œuvre, en partie lorsque la partie saillante des barreaux est de dimension Δ équivalente ou proche de l'épaisseur e des barreaux. Par exemple, on peut réaliser une diffusion contrôlée sur une distance de l'ordre de 3 nm pour obtenir un dopage sur toute l'épaisseur d'un barreau d'épaisseur de l'ordre de 6 nm.

Pour réaliser la diffusion de dopants, on effectue par exemple un recuit de type communément appelé « spike » de courte durée par exemple de l'ordre de une à plusieurs secondes à température élevée par exemple comprise entre 950°C -1050°C afin de permettre une migration et une activation de dopants dans le cœur du matériau semi-conducteur des portions semi-conductrices 15. Un recuit de température et de durée prévues de sorte à limiter la migration à plusieurs nm peut s'avérer suffisant afin de garder les dopants dans la zone d'extension sans qu'ils ne migrent jusqu'au canal.

Ainsi, un dopage uniforme des régions dites « d'extension » des barreaux 14₂, 14₄, 14₆, correspondant aux portions 15 faisant saillie situées en regard des blocs 12 latéraux du masquage peut être obtenu et ce sans doper une région située en regard du bloc 10 de grille factice.

Le fait de réaliser cette étape à ce moment du procédé plutôt qu'après l'étape décrite précédemment en lien avec la figure 1D permet d'éviter la désorption de dopants et ainsi de conserver une dose maximale.

On effectue ensuite une gravure du matériau diélectrique 21, de préférence de sorte à ne conserver ce matériau diélectrique 21 que dans une région située sous et en regard du masquage 10-12 (figure 1G). On forme ainsi des espaceurs internes 23 autour et entre les portions latérales 15 des barreaux semi-conducteurs 14₂, 14₄, 14₆.

Une gravure à l'aide d'un procédé de gravure humide (isotrope) ou une technique par gravure sèche (anisotrope) peut être utilisée. Le document "Vertically stacked-NanoWires MOSFETs in a replacement metal gate process with inner spacer and SiGe source/drain", de Barraud et al., Electron Devices Meeting (IEDM), 2016 IEEE International donne un exemple de procédé de réalisation d'espaceurs internes.

Par exemple, lorsque les barreaux semi-conducteurs 14₂, 14₄, 14₆ sont en silicium et les espaceurs internes 23 en nitrure de silicium (SiN), on effectue typiquement une gravure à base de H₃PO₄ pour retirer sélectivement des portions en excès de SiN.

Une gravure et/ou un nettoyage des barreaux 14₂, 14₄, 14₆ peut être ensuite réalisé afin de retirer une épaisseur des barreaux semi-conducteurs 14₂, 14₄, 14₆.

Une gravure afin d'ôter une éventuelle épaisseur résiduelle non désirée formée lors du dépôt de la fine couche sur les barreaux semi-conducteurs 14₂, 14₄, 14 afin d'effectuer un dopage peut être également effectuée à l'aide d'un procédé de gravure sèche, par exemple un plasma O₂.

Alternativement ou en complément, un nettoyage peut permettre notamment d'effectuer une désoxydation d'une éventuelle épaisseur de SiO₂ formée en surface des portions 15 faisant saillie des barreaux semi-conducteurs 14₂, 14₄, 14₆.

Lorsque les barreaux semi-conducteurs 14₂, 14₄, 14₆ sont en silicium, un nettoyage à l'aide de HF peut être utilisé pour permettre d'enlever des extrémités légèrement oxydées des portions 15, et de dévoiler des régions d'extrémité des barreaux semi-conducteurs 14₂, 14₄, 14₆. Le retrait par nettoyage et/ou gravure est effectué de préférence de sorte à enlever une épaisseur de matériau dopé au niveau des régions d'extrémité des barreaux 14₂, 14₄, 14₆ et dévoiler des régions d'extrémité à base de matériau semi-conducteur qui peut être non-dopé ou qui a été peu modifié par le dopage précédemment décrit, et donc de meilleure qualité cristalline.

La gravure et/ou le nettoyage évoqués précédemment permet(tent) ainsi de dévoiler des régions de meilleure qualité cristalline et de favoriser une croissance ultérieure de matériau semi-conducteur sur les portions 15 faisant saillie des barreaux semi-conducteurs 14₂, 14₄, 14₆.

On peut ensuite réaliser une telle croissance de matériau semi-conducteur sur les barreaux semi-conducteurs 14₂, 14₄, 14₆ à base du deuxième matériau 8, de sorte à former des blocs 26, 28 de source et de drain (figure 1H).

Un dopage *in-situ* peut être prévu lors de la formation des blocs 26, 28 de source et de drain.

On forme ensuite une encapsulation isolante 29 de la structure empilée.

Cette encapsulation peut être réalisée par dépôt d'une couche d'encapsulation à base de matériau diélectrique, par exemple à base d'oxyde de silicium de manière à recouvrir la structure, puis réaliser un retrait d'une épaisseur de cette couche d'encapsulation 29 de manière à dévoiler une face supérieure du masquage 10-12 correspondant au sommet de la structure empilée (figure 1I). Ce retrait peut être effectué par un procédé de planarisation de type CMP.

On retire ensuite le bloc 10 de grille factice tout en conservant les espaceurs 12 disposés de part et d'autre de ce bloc 10. Cela peut être réalisé par gravure sélective du matériau donné (figure 1J).

Lorsque le bloc de grille factice 10 central est à base de polysilicium, le retrait sélectif peut être réalisé par exemple à l'aide de TMAH. Le retrait du bloc de grille factice 10 conduit à la formation d'une ouverture 30 dévoilant l'empilement de barreaux 14₁, 14₃, 14₅, 14₇, 14₂, 14₄, 14₆. On réalise ensuite un retrait sélectif du premier matériau 6, de sorte à retirer les barreaux 14₁, 14₃, 14₅, 14₇ à base de ce matériau 6 et libérer ainsi une portion centrale des barreaux 14₂, 14₄, 14₆ semi-conducteurs (figure 1J). On forme ainsi une cavité 32 délimitant un emplacement de grille.

On dépose ensuite un diélectrique 35 de grille par exemple tel que du SiO₂ autour des barreaux 14₂, 14₄, 14₆ puis un matériau 36 de grille par exemple tel que du polysilicium afin de former une grille dans la cavité 32. Cette grille est enrobante de sorte qu'elle est agencée autour d'une portion centrale des barreaux semi-conducteurs 14₂, 14₄, 14₆ (figure 1K).

En variante de l'exemple de réalisation qui vient d'être décrit, une épaisseur des extrémités des portions 15 des barreaux semi-conducteurs 14₂, 14₄, 14₆, peut être retirée lors de la gravure de la couche de matériau diélectrique 23 effectuée en vue de former des espaceurs internes ou bien après une telle gravure.

Sur l'exemple de réalisation illustré sur les figures 3A-3B, on dévoile des régions de meilleure qualité cristalline et on favorise une croissance ultérieure de matériau semi-conducteur sur les portions 15 faisant saillie de barreaux semi-conducteurs 14₂, 14₄, 14₆.

Par exemple un nettoyage retirant sélectivement du Si dopé vis-à-vis du Si non dopé permet facilement l'obtention d'une extrémité cristalline sans défaut.

Un tel retrait peut être réalisé par exemple par gravure à l'aide de HCl lorsque les barreaux semi-conducteurs 14₂, 14₄, 14₆ sont en silicium afin d'obtenir des régions d'extrémités légèrement érodées en Si cristallin sur lesquelles on fera croitre les blocs de source et de drain. On peut également coupler un tel retrait avec un procédé de nettoyage au HF tel que décrit précédemment.

## Revendications

1. Procédé de réalisation d'un dispositif microélectronique comprenant au moins un transistor comportant une structure semi-conductrice dotée de barreaux semi-conducteurs disposés les uns au-dessus des autres, le procédé comprenant les étapes de :
- réalisation sur un support (1), d'une structure empilée comportant une alternance de plusieurs premiers barreaux (14₁, 14₃, 14s, 14₇) à base d'un premier matériau (6), et de plusieurs deuxièmes barreaux (14₂, 14₄, 14₆) à base d'un deuxième matériau (8), le deuxième matériau étant semi-conducteur, les deuxièmes barreaux (14₂, 14₄, 14₆) comportant des portions latérales (15) saillantes par rapport aux portions latérales des premiers barreaux puis,
- dopage en surface des portions latérales (15) de la structure, puis,
- formation d'espaceurs internes isolants (23) contre les premiers barreaux (14₁, 14₃, 14₅, 14₇), la formation des espaceurs internes isolants comprenant le dépôt d'une couche de matériau diélectrique sur l'empilement puis la gravure de la couche de matériau diélectrique, le procédé comprenant en outre lors de la gravure de la couche de matériau diélectrique ou après gravure de la couche de matériau diélectrique, un retrait d'une épaisseur de matériau au niveau de la face latérale des portions latérales saillantes et de sorte à dévoiler des régions d'extrémités des deuxièmes barreaux semi-conducteurs à base du deuxième matériau, puis
- formation de blocs de source (26) et de drain (28) par croissance de matériau semi-conducteur au niveau de régions d'extrémités desdites portions latérales (15).

2. Procédé selon la revendication 1, dans lequel les portions latérales (15) des premiers et deuxièmes barreaux forment un profil dentelé, le dopage en surface des portions latérales (15) saillantes étant conforme et réalisé de sorte à doper une face inférieure, une face latérale et une face supérieure des portions saillantes, et former ainsi une zone dopée dont l'agencement suit le profil dentelé.

3. Procédé selon la revendication 2, dans lequel le dopage en surface des portions latérales (15) comprend un dépôt conforme d'une fine couche à base d'un matériau dopé ou d'une fine couche d'espèce dopante sur les portions latérales.

4. Procédé selon la revendication 1, dans lequel le dopage en surface des portions latérales (15) est un dopage conforme réalisé à l'aide d'un plasma.

5. Procédé selon l'une des revendications 1 à 4, dans lequel, après formation des espaceurs internes isolants et avant formation des blocs de source et de drain on effectue un recuit thermique de diffusion de dopants.

6. Procédé selon l'une des revendications 1 à 5, dans lequel la formation de ladite structure empilée comprend des étapes de :
- réalisation d'un empilement comportant une alternance de couches (4₁, 4₃, 4₅, 4₇) à base du premier matériau et de couches (4₂, 4₄, 4₆) à base du deuxième matériau, et d'un masquage (10-12) sur ledit empilement,
- gravure anisotrope de l'empilement.

7. Procédé selon la revendication 6, dans lequel le masquage (10-12) est formé d'un bloc central (10) à base d'un matériau donné et reproduisant un motif de grille de transistor et de blocs latéraux (12) agencés de part et d'autre du bloc central (10), les blocs latéraux étant à base d'un autre matériau, diélectrique et différent dudit matériau donné, le procédé comprenant en outre, après croissance du matériau semi-conducteur au niveau de régions d'extrémités desdites portions latérales pour former les blocs de source (26) et de drain (28) :
- formation d'une couche isolante (29) d'encapsulation des blocs de source et de drain, de sorte qu'une face supérieure du bloc central est dévoilée,
- retrait du bloc central (10) par gravure sélective dudit matériau donné puis des premiers barreaux par gravure sélective dudit premier matériau, de sorte à former une cavité (30),
- formation d'une grille (35-36) dans la cavité (30).

8. Procédé selon l'une des revendications 1 à 7, dans lequel le retrait d'une épaisseur de matériau aux extrémités des portions latérales saillantes et de sorte à dévoiler des régions d'extrémités des deuxièmes barreaux semi-conducteurs, comprend une gravure sèche, en particulier mise en œuvre à l'aide d'un plasma O₂.

## Patentansprüche

1. Verfahren zur Herstellung einer mikroelektronischen Vorrichtung, die wenigstens einen Transistor mit einer Halbleiterstruktur mit übereinander angeordneten Halbleiterstäben umfasst, wobei das Verfahren die folgenden Schritte umfasst:
- Herstellen einer gestapelten Struktur auf einem Träger (1), die eine Abwechslung von mehreren ersten Stäben (14₁, 14₃, 14₅, 14₇) auf der Basis eines ersten Materials (6) und mehreren zweiten Stäben (14₂, 14₄, 14₆) auf der Basis eines zweiten Materials (8) umfasst, wobei das zweite Material ein Halbleiter ist, wobei die zweiten Stäbe (14₂, 14₄, 14₆) Seitenabschnitte (15) umfassen, die in Bezug auf die Seitenabschnitte der ersten Stäbe vorstehen, und ferner
- Oberflächendotierung der Seitenabschnitte (15) der Struktur, ferner
- Bilden von isolierenden inneren Abstandshaltern (23) gegen die ersten Stäbe (14₁, 14₃, 14₅, 14₇), wobei das Bilden der isolierenden inneren Abstandshalter das Aufbringen einer Schicht aus dielektrischem Material auf dem Stapel und dann das Ätzen der Schicht aus dielektrischem Material umfasst,
wobei das Verfahren ferner umfasst, dass während des Ätzens der Schicht aus dielektrischem Material oder nach dem Ätzen der Schicht aus dielektrischem Material eine Materialdicke an der Seitenfläche der vorstehenden Seitenabschnitte entfernt wird, so dass Endbereiche der zweiten Halbleiterstäbe auf der Basis des zweiten Materials freigelegt werden, ferner
- Bilden von Source- (26) und Drain-Blöcken (28) durch Aufwachsen von Halbleitermaterial an den Endbereichen der Seitenabschnitte (15).

2. Verfahren nach Anspruch 1, wobei die Seitenabschnitte (15) der ersten und zweiten Stäbe ein gezahntes Profil bilden, wobei die Oberflächendotierung der vorstehenden Seitenabschnitte (15) konform ist und so durchgeführt wird, dass eine Unterseite, eine Seitenfläche und eine Oberseite der vorstehenden Abschnitte dotiert werden und dadurch ein dotierter Bereich gebildet wird, dessen Anordnung dem gezahnten Profil folgt.

3. Verfahren nach Anspruch 2, wobei die Oberflächendotierung der Seitenabschnitte (15) ein konformes Aufbringen einer dünnen Schicht aus Dotiermaterial oder einer dünnen Schicht aus Dotiermaterial auf den Seitenabschnitten umfasst.

4. Verfahren nach Anspruch 1, wobei die Oberflächendotierung der Seitenabschnitte (15) eine konforme Dotierung unter Verwendung eines Plasmas ist.

5. Verfahren nach einem der Ansprüche 1 bis 4, wobei nach der Bildung der inneren isolierenden Abstandshalter und vor der Bildung der Source- und Drain-Blöcke ein thermisches Diffusionstempern des Dotiermaterials durchgeführt wird.

6. Verfahren nach einem der Ansprüche 1 bis 5, wobei die Bildung der gestapelten Struktur die folgenden Schritte umfasst:
- Herstellen eines Stapels, der abwechselnd Schichten (4₁, 4₃, 4₅, 4₇) auf Basis des ersten Materials und Schichten (4₂, 4₄, 4₆) auf Basis des zweiten Materials umfasst, und Maskieren (10-12) auf dem Stapel,
- anisotropes Ätzen des Stapels.

7. Verfahren nach Anspruch 6, wobei die Maskierung (10-12) aus einem zentralen Block (10), der auf einem bestimmten Material basiert und ein Transistor-Gate-Muster reproduziert, und aus Seitenblöcken (12), die auf beiden Seiten des zentralen Blocks (10) angeordnet sind, gebildet wird, die Seitenblöcke auf einem anderen Material basieren, das dielektrisch ist und sich von dem gegebenen Material unterscheidet, wobei das Verfahren ferner nach dem Aufwachsen des Halbleitermaterials an Endbereichen der Seitenabschnitte zur Bildung der Source-(26) und Drain-Blöcke (28) umfasst:
- Bilden einer Einkapselungs-Isolierschicht (29) der Source- und Drain-Blöcke, so dass eine Oberseite des zentralen Blocks freiliegt,
- Entfernen des Mittelblocks (10) durch selektives Ätzen des gegebenen Materials und anschließendes Entfernen der ersten Stäbe durch selektives Ätzen des genannten ersten Materials, so dass ein Hohlraum (30) entsteht,
- Bilden eines Gitters (35-36) in dem Hohlraum (30).

8. Verfahren nach einem der Ansprüche 1 bis 7, wobei das Entfernen einer Materialdicke an den Enden der vorstehenden Seitenabschnitte, um Endbereiche der zweiten Halbleiterstäbe freizulegen, ein Trockenätzen umfasst, das insbesondere unter Verwendung eines O₂-Plasmas durchgeführt wird.

## Claims

1. A method for fabricating a microelectronic device with at least a transistor comprising a semiconductor structure provided with semiconductor bars positioned above one another, the method comprising the following steps:
- forming, on a substrate (1), a stacked structure comprising an alternation of first bars (14₁, 14₃, 14₅, 14₇) of a first material and second bars (14₂, 14₄, 14₆) of a second material, the second material being a semiconductor, the second bars (14₂, 14₄, 14₆) comprising lateral portions protruding with respect to the lateral portion(s) of the first bar(s), then,
- surface doping the lateral portions (15) of the structure, then
- forming insulating inner spacers (23) against the first bars (14₁, 14₃, 14₅, 14₇), the forming of insulating inner spacers comprising depositing a dielectric material layer on the stacked structure then etching the dielectric material, the method further comprising, during etching of the layer of dielectric material or after etching of the dielectric material layer; a removal of a material thickness at the side face of the protuding lateral portions and so as to reveal end regions of the second semiconductor bars based on the second material, then
- forming source (26) and drain (28) blocks via growth of semiconductor material at regions of ends of said lateral portions (15).

2. The method according to claim 1, wherein the lateral portions (15) of the first and second bars form a serrated profile, the surface doping of the protruding lateral portions (15) being conformal and carried out in such a way as to conduct doping of a lower face, a lateral face and an upper face of the protruding portions, and thereby form a doped zone with an arrangement having the serrated profile.

3. The method according to claim 2, wherein the surface doping of the lateral portions (15) involves conformal deposition of a thin layer containing a doped material or a thin layer of doping species on the lateral portions.

4. The method according to claim 1, wherein the surface doping of the lateral portions (15) is a conformal doping carried out via a plasma.

5. The method according to any of the claims 1 to 4, wherein, after formation of the insulating inner spaces and before formation of the source and drain blocks, thermal annealing for diffusion of dopants is carried out.

6. The method according to any of the claims 1 to 5, wherein the formation of said stacked structure comprises the following steps:
- formation of a stack comprising an alternation of layers (4₃, 4₅, 4₇) containing the first material and layers (4₂, 4₄, 4₆) containing the second material, and of a mask (10-12) on said stack,
- anisotropic etching of the stack.

7. Method according to claim 6, wherein the mask (10-12) is formed by a central block (10) containing a given material and reproducing a transistor-gate pattern and lateral blocks (12) arranged on either side of the central block, the lateral blocks containing another material, dielectric and different from said given material, the method further comprising, after growth of the semiconductor material at regions of ends of said lateral portions so as to form source block and drain block:
- formation of an insulating layer (29) for encapsulating the source (26) and drain blocks (28), in such a way that an upper face of the central block is exposed,
- removal of the central block (10) via selective etching of said given material and then of the first bars via selective etching of said first material, in such a way as to form a cavity (30),
- formation of a gate (35-36) in the cavity (30).

8. The method according to any of the claims 1 to 7, wherein the removal of said material thickness at the side face of the protruding lateral portions and so as to reveal end regions of the second semiconductor bars based on the second material comprises a dry etch, advantageously conducted with an O₂ plasma.
